# EUROPÄISCHE PATENTSCHRIFT

(11) **EP 1 963 924 B1**
(45) Veröffentlichungstag und Bekanntmachung des Hinweises auf die Patenterteilung: **29.04.2015**
(21) Anmeldenummer: 06848832.9
(22) Anmeldetag: 21.12.2006
(51) Int. Cl.: G03F 7/20

(54) **OPTISCHE ABBILDUNGSEINRICHTUNG MIT BESTIMMUNG VON ABBILDUNGSFEHLERN**
OPTICAL IMAGING DEVICE WITH DETERMINATION OF IMAGING ERRORS
DISPOSITIF D'IMAGERIE OPTIQUE AVEC DETERMINATION DES ERREURS DE FORMATION D'IMAGE

(30) Priorität: 23.12.2005 US 753718 P; 23.12.2005 DE 102005062618
(43) Veröffentlichungstag der Anmeldung: 03.09.2008
(73) Patentinhaber: Carl Zeiss SMT GmbH, 73447 Oberkochen (DE); Kwan, Yim-Bun Patrick, 73431 Aalen (DE)
(72) Erfinder: KWAN, Yim-Bun Patrick, 73431 Aalen (DE)
(74) Vertreter: Cohausz & Florack
(86) Internationale Anmeldenummer: PCT/EP2006/070119
(87) Internationale Veröffentlichungsnummer: WO 2007/074134

(56) Entgegenhaltungen:
- EP-A- 1 063 570
- EP-A1- 1 213 618
- JP-A- 2001 274 059
- US-A1- 2002 041 377
- LAAN VAN DER H ET AL: "AERIAL IMAGE MEASUREMENT METHOD FOR FAST ABERRATION SET-UP AND ILLUMINATION PUPIL VERIFICATION" PROCEEDINGS OF THE SPIE, SPIE, BELLINGHAM, VA, US, Bd. 4346, Nr. PART 1/2, 27. Februar 2001 (2001-02-27), Seiten 394-407, XP008025417 ISSN: 0277-786X

## Beschreibung

### HINTERGRUND DER ERFINDUNG

Die vorliegende Erfindung betrifft eine optische Abbildungseinrichtung. Die Erfindung lässt sich im Zusammenhang mit der bei der Herstellung mikroelektronischer Schaltkreise verwendeten Mikrolithographie einsetzen. Sie betrifft daher weiterhin eine Maske für eine solche optische Abbildungseinrichtung. Schließlich betrifft die Erfindung ein Verfahren zur Bestimmung eines Abbildungsfehlers sowie ein dieses Verfahren verwendendes Abbildungsverfahren.

Insbesondere im Bereich der Mikrolithographie ist es neben der Verwendung mit möglichst hoher Präzision ausgeführter Komponenten unter anderem erforderlich, die Komponenten der Abbildungseinrichtung, also beispielsweise die optischen Elemente wie Linsen oder Spiegel, möglichst exakt zu positionieren, um eine entsprechend hohe Abbildungsqualität zu erzielen. Die hohen Genauigkeitsanforderungen, die im mikroskppischen Bereich in der Größenordnung weniger Nanometer oder darunter liegen, sind dabei nicht zuletzt eine Folge des ständigen Bedarfs, die Auflösung der bei der Herstellung mikroelektronischer Schaltkreise verwendeten optischen Systeme zu erhöhen, um die Miniaturisierung der herzustellenden mikroelektronischen Schaltkreise voranzutreiben.

Mit der erhöhten Auflösung und der damit in der Regel einhergehenden Verringerung der Wellenlänge des verwendeten Lichts steigen nicht nur die Anforderungen an die Positioniergenauigkeit der verwendeten optischen Elemente. Es steigen natürlich auch die Anforderungen hinsichtlich der Minimierung der Abbildungsfehler der gesamten optischen Anordnung.

Um bei den in der Mikrolithographie verwendeten geringen Arbeitswellenlängen im UV-Bereich, beispielsweise mit Arbeitswellenlängen im Bereich von 193 nm, insbesondere aber auch im so genannten extremen UV-Bereich (EUV) mit Arbeitswellenlängen im Bereich von 13 nm, die hohen Anforderungen an die Positionierung der beteiligten Komponenten einzuhalten, wird häufig vorgeschlagen, die Position der einzelnen Komponenten, wie den Maskentisch, die optischen Elemente und den Substrattisch (z. B. einem Wafer-Tisch), jeweils einzeln bezüglich einer Referenz - z. B. einer Referenzstruktur, die häufig von einem so genannten Metrology Frame gebildet wird - zu erfassen und diese Komponenten dann aktiv zueinander zu positionieren.

Diese Lösung hat zum einen den Nachteil, dass in der Regel keine Echtzeitmessung der Position der Abbildung des Projektionsmusters der Maske auf dem Substrat (meist einem Wafer) erfolgt, sondern lediglich indirekt aus den einzelnen Positionsdaten der Komponenten bezüglich der Referenz auf deren Relativposition und die Position der Abbildung geschlossen wird. Hierbei summieren sich die jeweiligen Messfehler, sodass es gegebenenfalls zu einem vergleichsweise hohen gesamten Messfehler kommen kann. Weiterhin ist hiermit eine große Anzahl von aktiv zu positionierenden Elementen verbunden, welche alle mit der entsprechenden Winkelgenauigkeit im Nanorad-Bereich (nrad) und einer Translationsgenauigkeit im Pikometer-Bereich (pm) positioniert und hinsichtlich ihrer Position erfasst werden müssen. Dies zieht zudem besonders hohe Anforderungen an die thermische Stabilität der Referenz und der Stützstruktur für die optischen Elemente nach sich. Hier sind hinsichtlich der thermischen Ausdehnung in der Regel nur wenige Dutzend Nanometer pro Kelvin (nm/K) zulässig.

Demgegenüber ist weiterhin eine Reihe von Lösungen bekannt, bei denen die Position der Abbildung des Projektionsmusters der Maske auf dem Substrat in Echtzeit bestimmt wird. Hierbei kann die Position der Abbildung des Projektionsmusters auf dem Substrat mit deutlich weniger aktiven Elementen, gegebenenfalls sogar nur mit einem aktiven Element, korrigiert werden. Dadurch vereinfacht sich nicht nur die dynamische Ansteuerung der übrigen Komponenten, es sind auch deutlich geringere Anforderungen an die thermische Stabilität der Referenz und der Stützstruktur für die optischen Elemente zu stellen.

Die Echtzeitbestimmung der Position der Abbildung des Projektionsmusters der Maske auf dem Substrat erfolgt häufig nach dem so genannten Laser-Pointer-Prinzip. Hierbei wird von einer im Bereich der Maske angeordneten Lichtquelle ein kollimierter Laserstrahl in der Nähe des Pfades des Nutzlichts über die an der Abbildung beteiligten optischen Elemente bis in den Bereich des Substrats geführt und dort über einen Detektor erfasst. Schon geringste Abweichungen der optischen Elemente von ihrer Sollposition erzeugen hierbei eine Abweichung des Laserstrahls von seiner Sollposition, die über den Detektor erfasst und zur Korrektur herangezogen wird. Ein derartiges Verfahren ist beispielsweise aus der US 2003/0234993 A1 (Hazelton et al.) bekannt.

Hierbei lassen sich dank der Führung des Laserstrahls über die an der Abbildung beteiligten optischen Elemente gegebenenfalls nicht nur Abweichungen hinsichtlich der korrekten Position der Abbildung des Projektionsmusters der Maske auf dem Substrat bestimmen, sondern es können auch weitere Fehler (z. B. Verzerrungen etc.) bei der Abbildung erfasst werden. Alle diese Positionsfehler und sonstigen Fehler werden in der vorliegenden Beschreibung unter dem Begriff Abbildungsfehler zusammengefasst.

Auch diese Lösung hat wiederum den Nachteil, dass nunmehr an die Position der Lichtquelle und des Detektors die entsprechenden strengen Anforderungen hinsichtlich der Winkelgenauigkeit im Nanorad-Bereich (nrad) und der Translationsgenauigkeit im PikometerBereich (pm) sowie hinsichtlich der thermischen Stabilität gestellt werden. Vor allen Dingen die Lichtquelle muss dabei in der Regel über eine aufwändige, thermisch stabile Stützstruktur abgestützt werden, die in der Regel weit entfernt von der Referenz (z. B. einem so genannten Metrology Frame) angeordnet ist. Zudem muss meist wiederum eine aufwändige Positionsbestimmung dieser Komponenten bezüglich einer Referenz erfolgen, die dann in die Korrekturermittlung mit einfließt.

US 2002/0041377 A1 offenbart eine optische Abbildungseinrichtung entsprechend der Präambel des Anspruchs 1.

### KURZE ZUSAMMENFASSUNG DER ERFINDUNG

Der vorliegenden Erfindung liegt daher die Aufgabe zu Grunde, eine optische Abbildungseinrichtung, eine Maske hierfür, ein Verfahren zur Bestimmung von Abbildungsfehlern bzw. ein Abbildungsverfahren zur Verfügung zu stellen, welche bzw. welches die oben genannten Nachteile nicht oder zumindest in geringerem Maße aufweist und insbesondere auf einfache Weise in Echtzeit eine möglichst unmittelbare Bestimmung und gegebenenfalls Korrektur von Abbildungsfehlern ermöglicht.

Der vorliegenden Erfindung liegt weiterhin die Aufgabe zu Grunde, eine optische Abbildungseinrichtung, eine Maske hierfür, ein Verfahren zur Bestimmung von Abbildungsfehlern bzw. ein Abbildungsverfahren zur Verfügung zu stellen, welche bzw. welches eine möglichst unmittelbare Bestimmung und gegebenenfalls Korrektur von Abbildungsfehlern mit wenigen Elementen ermöglicht.

Der vorliegenden Erfindung liegt die Erkenntnis zu Grunde, dass eine solche unmittelbare Bestimmung und gegebenenfalls Korrektur von Abbildungsfehlern in einfacher Weise möglich ist, wenn eine Positionsbestimmung der Maske in der Nähe des Substrats über wenigstens einen Großteil der an der Abbildung des Projektionsmusters der Maske auf dem Substrat beteiligten ersten optischen Elemente bzw. damit in Wirkverbindung stehende zweite optische Elemente erfolgt. Hierzu wird erfindungsgemäß über wenigstens einen Großteil der an der Abbildung des Projektionsmusters der Maske auf dem Substrat beteiligten ersten optischen Elemente bzw. damit in Wirkverbindung stehende zweite optische Elemente eine Messabbildung eines im Bereich der Maske bzw. des Projektionsmusters angeordneten Messelements erzeugt, die dann ausgewertet wird, um den Abbildungsfehler zu bestimmen.

Die Verwendung eines Messelements hat dabei den Vorteil, dass es ohne weiteres in eine entsprechend definierte und stabile Position zu der Maske bzw. deren Projektionsmuster gebracht werden kann, sodass anders als bei den bekannten Laser-Pointer-Verfahren, bei denen die aktive Lichtquelle entsprechend definiert und stabil positioniert werden muss, nur geringer Aufwand hierfür betrieben werden muss. Insbesondere ist es mit der Erfindung möglich, ein passives Messelement in einfacher Weise direkt an der Maske, gegebenenfalls in unmittelbarer Nähe des Projektionsmusters, anzubringen. Zusätzlich oder alternativ zur Verwendung eines solchen Messelements kann für die Messabbildung aber auch zumindest ein Teil des Projektionsmusters verwendet werden.

Die hiermit mögliche direkte Erfassung der Messabbildung und damit unter anderem der Maskenposition in unmittelbarer Nähe des Substrats hat eine Reihe von Vorteilen. So werden jegliche Fehler (Positionsfehler, dynamische Fehler, thermische Fehler etc.), die von den optischen Elementen, der Maskeneinrichtung, der Substrateinrichtung oder einer Referenz herrühren, ausgeblendet. Die so erfasste Messabbildung entspricht zumindest in guter Näherung der tatsächlichen Abbildung des Projektionsmusters auf dem Substrat, sodass auf dieser Basis eine entsprechende Korrektur vorgenommen werden kann. Die Abweichung der Erfassungsposition von der Substratposition kann gegebenenfalls über eine entsprechende Referenzmessung der Erfassungsposition bezüglich der Substratposition einfach erfasst und berücksichtigt werden. Weiterhin ist es hiermit im Übrigen auch möglich, jeglichen Vergrößerungsfehler der optischen Elementgruppe sowie jeglichen Skalierungsfehler von weiteren Referenzmesssystemen automatisch, gegebenenfalls in einem einzigen Schritt, zu korrigieren.

Eine Korrektur der so ermittelten Abbildungsfehler kann einfach über wenigstens eine der an der Abbildung beteiligten Komponenten vorgenommen werden. So kann gegebenenfalls nur eine der an der Abbildung beteiligten aktiv steuerbaren Komponenten zur Korrektur verwendet werden. Bevorzugt handelt es sich hierbei um eine Komponente mit einer hohen Steuerbandbreite. Hierbei kann es sich bei der aktiv steuerbaren Komponente gegebenenfalls um die Substrateinrichtung selbst handeln. Es kann sich aber auch um eines der optischen Elemente handeln. Gegebenenfalls kann auch eine entsprechende automatische Regelung des Korrekturvorgangs vorgesehen sein, welche die Korrektur des Abbildungsfehlers an sich ändernde Randbedingungen anpasst.

Ein Gegenstand der vorliegenden Erfindung ist daher eine optische Abbildungseinrichtung nach Anspruch 1 oder Anspruch 23.

Ein weiterer Gegenstand der vorliegenden Erfindung ist ein Abbildungsverfahren nach Anspruch 12 oder Anspruch 26.

Weitere bevorzugte Ausgestaltungen der Erfindung ergeben sich aus den Unteransprüchen.

### KURZE BESCHREIBUNG DER ZEICHNUNGEN

- Figur 1: ist eine schematische Darstellung einer bevorzugten Ausführungsform der erfindungsgemäßen optischen Abbildungseinrichtung mit einer bevorzugten Ausführungsform der erfindungsgemäßen Maske;
- Figur 2: ist eine schematische Ansicht der Maske aus Figur 1;
- Figur 3: ist ein Ablaufdiagramm einer bevorzugten Ausführungsform des erfindungsgemäßen Abbildungsverfahrens mit der Abbildungseinrichtung aus Figur 1, bei dem eine bevorzugte Ausführungsform des erfindungsgemäßen Verfahrens zum Erfassen von Abbildungsfehlern Anwendung findet;
- Figur 4: ist ein Ablaufdiagramm einer Ausführungsform eines Abbildungsverfahrens.

### DETAILLIERTE BESCHREIBUNG DER ERFINDUNG

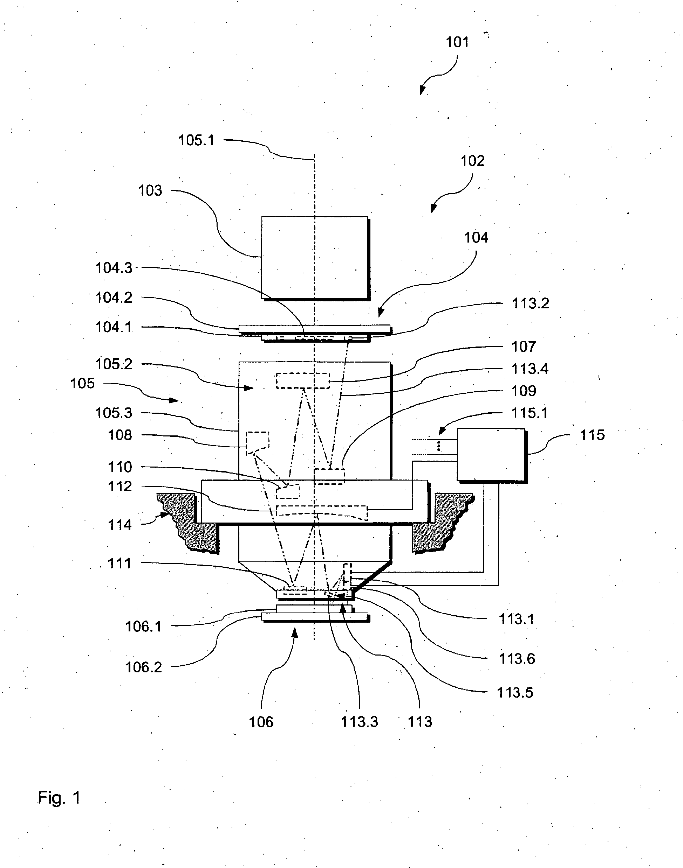

Unter Bezugnahme auf die Figuren 1 bis 3 wird im Folgenden eine bevorzugte Ausführungsform des erfindungsgemäßen optischen Abbildungseinrichtung für die Mikrolithographie beschrieben.

Figur 1 zeigt eine schematische Darstellung einer bevorzugten Ausführungsform der erfindungsgemäßen optischen Abbildungseinrichtung in Form einer Mikrolithographieeinrichtung 101, die mit Licht einer ersten Wellenlänge im extremen UV-Bereich (EUV) arbeitet. Die Mikrolithographieeinrichtung 101 umfasst ein optisches Projektionssystem 102 mit einem Beleuchtungssystem 103, einer Maske 104 und einer optischen Einrichtung in Form eines Objektivs 105 mit einer optischen Achse 105.1. Das Beleuchtungssystem 103 beleuchtet über ein entsprechendes - nicht näher dargestelltes - Lichtleitsystem die reflektierend ausgebildete Maske 104.1 einer Maskeneinrichtung 104 mit einem - nicht näher dargestellten - Projektionslichtbündel. Auf der Maske 104.1, die auf einem Maskentisch 104.2 angeordnet ist, befindet sich ein Projektionsmuster 104.3, welches mit dem Projektionslichtbündel über die im Objektiv 105 angeordneten optischen Elemente auf ein Substrat 106.1, beispielsweise einen Wafer, einer Substrateinrichtung 106 projiziert wird.

Das Objektiv 105 umfasst eine optische Elementgruppe 105.2, die von einer Reihe von ersten optischen Elementen 107, 108, 109, 110; 111, 112 gebildet ist, die im Gehäuse 105.3 des Objektivs 105 gelagert sind. Wegen der Arbeitswellenlänge im EUV-Bereich (ca. 13 nm) handelt es sich bei den optischen Elementen 107, 108, 109, 110, 111, 112 um reflektierende optische Elemente, also Spiegel oder dergleichen.

Weiterhin ist eine Messeinrichtung 113 vorgesehen, die eine am Gehäuse 105.3 des Objektivs 105 befestigte Erfassungseinheit in Form eines Encoders 113.1, mehrere im Bereich der Maskeneinrichtung 104 angeordnete Messelemente 113.2 und eine am Gehäuse 105.3 des Objektivs 105 befestigte Lenkeinrichtung 113.3 umfasst.

Der Encoder 113.1 erfasst eine Messabbildung der Messelemente 113.2, die - wie in Figur 1 durch den Strahlengang 113.4 eines Messlichtbündels angedeutet ist - über sämtliche optische Elemente 107, 108, 109, 110, 111, 112 und die Lenkeinrichtung 113.3 auf den Encoder 113.1 geführt wird. Die Erfassung erfolgt dabei bei einer zweiten Wellenlänge des Messlichtbündels, die von der ersten Wellenlänge des Projektionslichtbündels zur Abbildung des Projektionsmusters 104.3 auf den Wafer 106.1 abweicht und auf die maximale Empfindlichkeit des Encoders 113.1 hin optimiert ist. Es versteht sich jedoch, dass bei anderen Varianten der Erfindung die Erfassung der Messabbildung auch bei der Wellenlänge der Abbildung des Projektionsmusters auf den Wafer erfolgen kann. Insbesondere kann das Messlichtbündel hierzu durch geeignete Mittel von dem Projektionslichtbündel abgezweigt werden.

Die Lenkeinrichtung 113.3 ist im vorliegenden Beispiel ein in der Nähe des Wafers 106.1 am Gehäuse 105.3 des Objektivs 105 befestigter Umlenkspiegel. Hiermit kann der Encoder 113.1 an einer Position im Gehäuse 105.3 des Objektivs 105 angeordnet werden, die im Hinblick auf seinen Einbau, seine Zugänglichkeit und/oder die Gestaltungsfreiheit anderer Komponenten günstig ist. Es versteht sich jedoch, dass bei anderen Varianten der Erfindung auch eine andersartig ausgebildete Lenkeinrichtung vorgesehen sein kann. Insbesondere ist es auch möglich, dass das Substrat bei entsprechenden reflektierenden Eigenschaften zumindest als Teil der Lenkeinrichtung fungiert, wie dies in Figur 1 durch den gepunkteten Strahlengang 113.5 angedeutet ist. In diesem Fall kann dann gegebenenfalls eine Lenkeinrichtung, die eine Abschattung für die Abbildung des Projektionsmusters auf den Wafer erzeugen würde, entfalten.

Weiterhin umfasst die Messeinrichtung 113 eine in unmittelbarer Nähe des Encoders 113:1 am Gehäuse 105.3 des Objektivs 105 angeordnete Lagebestimmungseinrichtung in Form einer Referenzmesseinrichtung 113.6. Über diese Referenzmesseinrichtung 113.6 wird in herkömmlicher Weise die Relativposition des Wafers 106.1 zum Encoder 113.1 bestimmt.

Das Gehäuse 105.3 des Objektivs 105 stellt mit anderen Worten ein Referenzelement dar, bezüglich dessen die oben genannten Messungen vorgenommen werden. Es versteht sich jedoch, dass bei anderen Varianten der Erfindung auch andere Komponenten der Abbildungseinrichtung als Referenzelement dienen können. So kann beispielsweise die Stützstruktur 114 für das Gehäuse 105.3 des Objektivs 105, die häufig als Metrology Frame bezeichnet wird, als Referenzelement fungieren. Ebenso kann aber auch eines der optischen Elemente 107, 108, 109, 110, 111, 112 das Referenzelement bilden. Besonders geeignet sind hierfür insbesondere schwere Spiegel oder dergleichen, die in der Nähe des Substrats angeordnet sind. Schließlich kann auch die Substrateinrichtung, beispielsweise der Substrattisch, das Referenzelement bilden, indem beispielweise der Encoder am Substrattisch angeordnet ist.

Weiterhin versteht es sich, dass die Messabbildung der Messelemente bei anderen Varianten der Erfindung gegebenenfalls auch nur über einen Großteil der optischen Elemente der optischen Elementgruppe geführt werden kann, mit hin also einzelne der optischen Elemente, beispielsweise am Ende des Strahlenganges, ausgespart werden können. Dies ist insbesondere dann möglich, wenn das betreffende ausgesparte optische Element hinsichtlich seiner Lage und thermisch ausreichend stabil ist und/oder selbst das Referenzelement bildet.

Aus der Messabbildung und der durch die Referenzmesseinrichtung 113.6 bestimmten Relativposition des Wafers 106.1 zum Encoder 113.1 können in Echtzeit der bzw. die Abbildungsfehler bei der Abbildung des Projektionsmusters 104.3 auf den Wafer 106.1 bestimmt werden. So kann beispielsweise über eine Abweichung der Messabbildung im Encoder 113.1 von einem Sollzustand auf eine Abweichung der Abbildung des Projektionsmusters 104.3 auf den Wafer 106.1 von der Sollposition und/oder der Sollgeometrie geschlossen werden.

So lassen sich aus über die Messabbildung erfassten Positionsabweichungen Rückschlüsse auf die Position der an der Abbildung des Projektionsmusters 104.3 auf den Wafer 106.1 beteiligten Komponenten ziehen, während aus über die Messabbildung erfassten Geometrieabweichungen Rückschlüsse auf weitere Abbildungsfehler bei der Abbildung des Projektionsmusters 104.3 auf den Wafer 106.1 ziehen lassen.

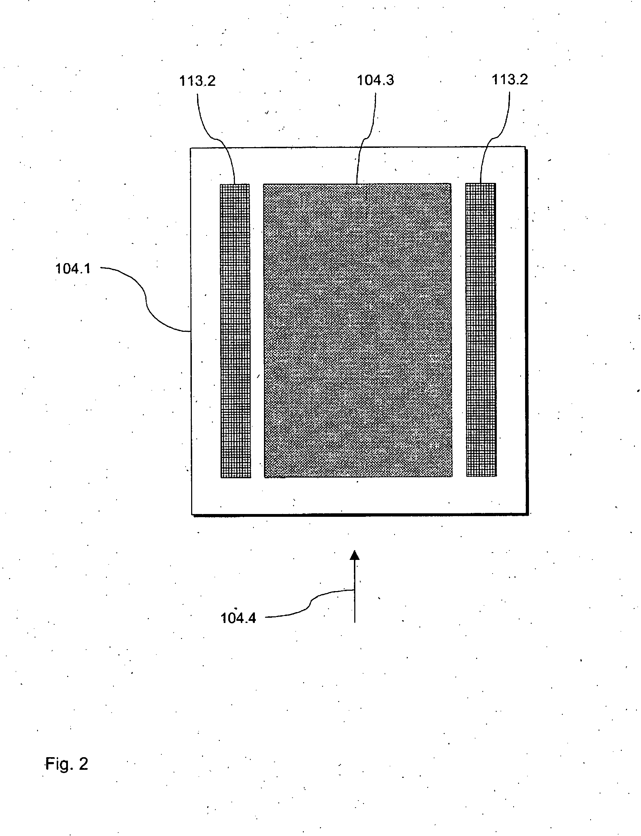

Wie Figur 2 zu entnehmen ist, sind die Messelemente 113.2 im vorliegenden Beispiel zwei Messmuster in Form zweidimensionaler Gitter, die seitlich unmittelbar neben dem Projektionsmuster 104.3 auf die Maske 104.1 aufgebracht sind und sich entlang der Scan-Richtung 104.4 der Maskeneinrichtung 104 erstrecken. Die zweidimensionalen Gitter 113.2 können beispielsweise durch ein entsprechendes einfaches Belichtungsverfahren oder dergleichen auf die Maske 104.1 aufgebracht worden sein. Gegebenenfalls kann dies zur gleichen Zeit und/oder mit dem selben Verfahren wie das Aufbringen des Projektionsmuster 104.3 erfolgen.

Mit solchen zweidimensionalen Gittern 113.2 lassen sich die oben beschriebenen Positionsabweichungen besonders einfach erfassen, da der Encoder 113.1 dann dank den bekannten Gittergeometrie gegebenenfalls lediglich nach einer entsprechenden Kalibrierung lediglich die aus der Verschiebung der Messabbildung des jeweiligen Gitters 113.2 resultierenden Impulse erfassen und zählen muss, um auf die Positionsabweichung zu schließen.

Weiterhin kann der Encoder 113.1 aber auch Abweichungen in der Geometrie der Messabbildung des jeweiligen Gitters 113.2, beispielsweise eine Verzerrung der Messabbildung des jeweiligen Gitters 113.2, erfassen, und hieraus Rückschlüsse auf weitere Abbildungsfehler bei der Abbildung des Projektionsmusters 104.3 auf den Wafer 106.1 ziehen.

Es versteht sich in diesem Zusammenhang, dass bei anderen Varianten der Erfindung an Stelle der zweidimensionalen Gitter 113.2 auch jeweils wenigstens zwei eindimensionale Gitter unterschiedlicher Ausrichtung zum Einsatz kommen können. Es versteht sich hierbei weiterhin, dass bei anderen Varianten der Erfindung an Stelle der Gitter 113.2 bzw. des Encoders 113.1 gegebenenfalls auch beliebige andere Messelemente und/oder Erfassungseinheiten verwendet werden können, welche anhand der Messabbildung eine Erfassung der Positionsabweichungen und/oder weiterer Abbildungsfehler ermöglichen.

Weiterhin versteht es sich, dass das Messelement bzw. die Messelemente bei anderen Varianten der Erfindung auch nicht unmittelbar an der Maske angeordnet sein müssen. Vielmehr ist es beispielsweise ebenfalls möglich, das Messelement bzw. die Messelemente an dem Maskentisch in der Nähe der Maske bzw. des Projektionsmusters anzuordnen. Gegebenenfalls ist es sogar möglich, das Messelement bzw. die Messelemente separat von der Maskeneinrichtung in der Nähe der Maske bzw. des Projektionsmusters anzuordnen, sofern eine definierte räumliche Beziehung zur Maske bzw. zum Projektionsmuster sichergestellt ist.

Die Verwendung der direkt an der Maske 104.1 angebrachten passiven Messelemente 113.2 hat dabei den Vorteil, dass sie ohne weiteres in eine entsprechend definierte und stabile Position zu der Maske 104.1 bzw. deren Projektionsmuster 104.3 haben. Anders als bei den bekannten Laser-Pointer-Verfahren, bei denen die aktive Lichtquelle entsprechend definiert und stabil positioniert werden muss, ist hierfür nur geringer Aufwand zu betreiben.

Die direkte Erfassung der Messabbildung und damit unter anderem der Position der Maske 104.1 in unmittelbarer Nähe des Wafers 106.1 hat eine Reihe von Vorteilen. So werden jegliche Messfehler (Positionsfehler, dynamische Fehler, thermische Fehler etc.), die von den optischen Elementen 107, 108, 109, 110, 111, 112, der Maskeneinrichtung 104 und der Substrateinrichtung 106 und der Stützstruktur 114 etc. herrühren, ausgeblendet. Die so erfasste Messabbildung entspricht zumindest in guter Näherung der tatsächlichen Abbildung des Projektionsmusters 104.3 auf dem Wafer 106.1, sodass auf dieser Basis, wie im Folgenden noch näher erläutert wird, eine entsprechende Korrektur vorgenommen werden kann. Die Abweichung der Erfassungsposition, also der Position des Encoders 113.1, von der Substratposition, also der Position des Wafers 106.1, wird über die Referenzmessung der Referenzmesseinrichtung 113.5 erfasst und berücksichtigt. Weiterhin ist es hiermit im Übrigen auch möglich, jeglichen Vergrößerungsfehler der optischen Elementgruppe sowie jeglichen Skalierungsfehler von weiteren Referenzmesssystemen automatisch, gegebenenfalls in einem einzigen Schritt, zu korrigieren.

Die Korrektur der durch den Encoder 113.1 ermittelten Abbildungsfehler wird über eine mit der Messeinrichtung 113 verbundene Korrektureinrichtung in Form einer Steuereinrichtung 115 vorgenommen. Die Steuereinrichtung 115 ist als zentrale Steuereinrichtungen mit den an der Abbildung des Projektionsmusters 104.3 auf dem Wafer 106.1 beteiligten aktiven Komponenten verbunden, wie dies in Figur 1 durch die - teils nur angedeuteten - Steuerleitungen 115.1 angedeutet ist. Hierbei versteht es sich, dass die Verbindung zu den aktiven Komponenten nicht notwendigerweise über eine permanent bestehende, fest verdrahtete Verbindung handeln muss. Vielmehr kann es sich auch um eine gegebenenfalls nur zeitweise bestehende, zumindest abschnittsweise drahtlose Verbindung handeln.

Die Steuereinrichtung 115 verarbeitet die durch den Encoder 113.1 ermittelten Abbildungsfehler und errechnet daraus Steuerbefehle für die Stellelemente einer der an der Abbildung des Projektionsmusters 104.3 auf dem Wafer 106.1 beteiligten aktiven Komponenten. Im vorliegenden Beispiel ist diese aktive Komponente das letzte optische Element 112 im Strahlengang der Abbildung des Projektionsmusters 104.3 auf dem Wafer 106.1.

Es versteht sich jedoch, dass bei anderen Varianten der Erfindung gegebenenfalls auch ein oder mehrere andere an der Abbildung des Projektionsmusters 104.3 auf dem Wafer 106.1 beteiligte Komponenten als aktive Komponenten ausgebildet sein können und zur Korrektur der ermittelten Abbildungsfehler herangezogen werden können. Bevorzugt handelt es sich hierbei um eine Komponente mit einer hohen Steuerbandbreite. Hierbei kann es sich gegebenenfalls um die Substrateinrichtung selbst handeln.

Weiterhin versteht es sich, dass die Steuerbefehle für die Stellelemente der an der Abbildung des Projektionsmusters 104.3 auf dem Wafer 106.1 beteiligten aktiven Komponenten auch auf andere Weise ermittelt werden können. So können diese beispielsweise direkt entsprechenden Tabelle (so genannte Look-Up-Tables) und/oder gegebenenfalls anderweitig hinterlegten Modellen entnommen werden.

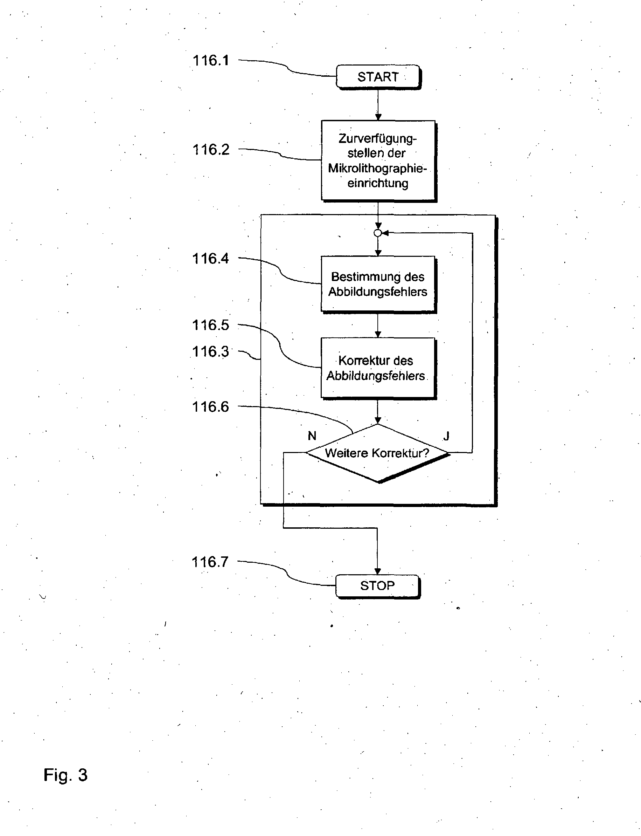

Figur 3 zeigt ein Ablaufdiagramm einer bevorzugten Ausführungsform des erfindungsgemäßen Abbildungsverfahrens in Form eines Mikrolithographieverfahrens, das mit der nach dem so genannten Scanner-Prinzip arbeitenden Mikrolithographieeinrichtung 101 aus den Figuren 1 und 2 durchgeführt wird und bei dem eine bevorzugte Ausführungsform des Verfahrens zum Bestimmen des Abbildungsfehlers zur Anwendung kommt.

Zunächst wird in einem Schritt 116.1 der Verfahrensablauf des Mikrolithographieverfahrens gestartet. In einem Schritt 116.2 wird dann die Mikrolithographieeinrichtung 101 aus Figur 1 zur Verfügung gestellt.

In einem Abbildungsschritt 116.3 erfolgt parallel zur Belichtung des Wafers 106.1 zunächst in einem Bestimmungsschritt 116.4 eine Bestimmung des Abbildungsfehlers. Hierzu wird, wie oben im Zusammenhang mit den Figuren 1 und 2 beschrieben, die Messabbildung der zweidimensionalen Gitter 113.2 in dem Encoder 113.1 sowie die Referenzmessung durch die Referenzmesseinrichtung 113.6 vorgenommen und deren Ergebnisse durch eine, beispielsweise in den Encoder 113.1 integrierte, Verarbeitungseinheit der Messeinrichtung 113 verarbeitet.

In Abhängigkeit von dem hieraus bestimmten Abbildungsfehler bei der Abbildung des Projektionsmusters 104.3 auf dem Wafer 106.1 erfolgt dann durch die Steuereinrichtung 115 in dem Korrekturschritt 116.5 die oben im Zusammenhang mit den Figuren 1 und 2 beschriebene Korrektur des Abbildungsfehlers, indem die Steuereinrichtung 115 die Stellelemente des optischen Elements 112 entsprechend ansteuert.

Wie erwähnt, erfolgt die Bestimmung und Korrektur des Abbildungsfehlers parallel zur Belichtung des Wafers 106.1. Zumindest solange keine Abbildungsfehler erfasst werden, welche einen Abbruch der Belichtung des Wafers 106.1 erforderliche machen würden, erfolgt die Belichtung also gleichzeitig mit und unabhängig von der Bestimmung und Korrektur des Abbildungsfehlers.

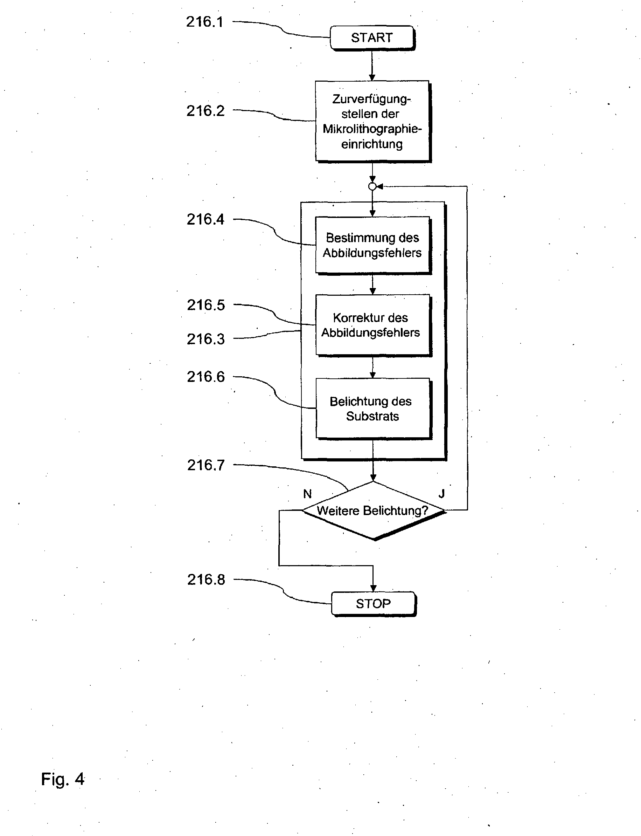

In einem weiteren Schritt 116.6 wird dann überprüft, ob noch ein weiterer Korrekturvorgang vorgenommen werden soll. Ist dies nicht der Fall, wird der Verfahrensablauf in dem Schritt 116.7 beendet. Andernfalls wird zurück zu dem Schritt 116.4 gesprungen. Figur 4 zeigt ein Ablaufdiagramm einer Ausführungsform eines Abbildungsverfahrens in Form eines Mikrolithographieverfahrens, das mit der dann nach dem so genannten Stepper-Prinzip arbeitenden Mikrolithographieeinrichtung aus den Figuren 1 und 2 durchgeführt wird und bei dem ein Verfahren zum Bestimmen des Abbildungsfehlers zur Anwendung kommt.

Zunächst wird in einem Schritt 216.1 der Verfahrensablauf des Mikrolithographieverfahrens gestartet. In einem Schritt 216.2 wird dann die Mikrolithographieeinrichtung 101 aus Figur 1 zur Verfügung gestellt.

In einem Abbildungsschritt 216.3 erfolgt zunächst in einem Bestimmungsschritt 216.4 eine Bestimmung des Abbildungsfehlers. Hierzu wird, wie oben im Zusammenhang mit den Figuren 1 und 2 beschrieben, die Messabbildung der zweidimensionalen Gitter 113.3 in dem Encoder 113.1 sowie die Referenzmessung durch die Referenzmesseinrichtung 113.6 vorgenommen und deren Ergebnisse durch eine, beispielsweise in den Encoder 113.1 integrierte, Verarbeitungseinheit der Messeinrichtung 113 verarbeitet.

In Abhängigkeit von dem hieraus bestimmten Abbildungsfehler bei der Abbildung des Projektionsmusters 104.3 auf dem Wafer 106.1 erfolgt dann durch die Steuereinrichtung 115 in dem Korrekturschritt 216.5 die oben im Zusammenhang mit den Figuren 1 und 2 beschriebene Korrektur des Abbildungsfehlers, indem die Steuereinrichtung 115 die Stellelemente des optischen Elements 112 entsprechend ansteuert.

In einem weiteren Schritt 216.6 wird dann der Wafer 106.1 belichtet. Nachfolgend wird in einem Schritt 216.7 überprüft, ob noch ein weiterer Belichtungsvorgang vorgenommen werden soll. Ist dies nicht der Fall, wird der Verfahrensablauf in dem Schritt 216.8 beendet. Andernfalls wird zurück zu dem Schritt 216.3 gesprungen.

Bei weiteren Varianten der Erfindung wird die Messabbildung nicht oder nicht ausschließlich über die ersten optischen Elemente 107, 108, 109, 110, 111, 112 erzeugt, sondern zumindest teilweise über eine Reihe von zweiten optischen Elementen, von denen jeweils eines oder mehrere in Wirkverbindung mit einem der ersten optischen Elemente 107, 108, 109, 110, 111, 112 stehen. Das betreffende zweite optische Element kann hierzu beispielsweise fest mit dem jeweiligen ersten optischen Element 107, 108, 109, 110, 111, 112 verbunden sein, sodass sich eine bekannte bzw. hinreichend genau bestimm- oder abschätzbare Korrelation zwischen Zustandsänderungen (z.B. Positionsänderungen) des jeweiligen ersten optischen Elements 107, 108, 109, 110, 111, 112 und des mit ihm verbundenen zweiten optischen Elements ergibt.

Bei den zweiten optischen Elementen kann es sich - gegebenenfalls in Abhängigkeit von der Wellenlänge des Messlichtbündels - ausschließlich oder in beliebiger Kombination um refraktive, reflektive oder diffraktive optische Elemente handeln.

Weiterhin versteht es sich, dass es sich bei der Messabbildung nicht oder nicht ausschließlich um eine Abbildung gesonderter Messelemente handeln kann. Vielmehr kann auch vorgesehen sein, dass es sich bei der Messabbildung ganz oder teilweise um eine mittels des Messlichtbündels erzeugte Abbildung zumindest eines Teils des Projektionsmusters 104.3 handelt. Das Projektionsmuster 104.3 weist in der Regel ebenfalls eine hinreichend bekannte und erfassbare Struktur auf, sodass aus seiner Abbildung mittels des Messlichtbündels ebenfalls der Abbildungsfehler hinreichend genau bestimmt werden kann.

Die vorliegende Erfindung wurde vorstehend anhand von Beispielen beschrieben, bei denen die optische Elementgruppe ausschließlich aus reflektiven optischen Elementen besteht. Es sei an dieser jedoch Stelle angemerkt, dass die Erfindung natürlich auch, insbesondere für den Fall der Abbildung bei anderen ersten Wellenlängen, bei optischen Elementgruppen Anwendung finden kann, die alleine oder in beliebiger Kombination refraktive, reflektive oder diffraktive optische Elemente umfassen.

Weiterhin ist anzumerken, dass die vorliegende Erfindung vorstehend anhand eines Beispiels aus dem Bereich der Mikrolithographie beschrieben wurde. Es versteht sich jedoch, dass die vorliegende Erfindung ebenso auch für beliebige andere Anwendungen bzw. Abbildungsverfahren eingesetzt werden kann.

## Patentansprüche

1. Optische Abbildungseinrichtung, insbesondere für die Mikrolithographie, mit
- einer Maskeneinrichtung (104) zur Aufnahme einer ein Projektionsmuster (104.3) umfassenden Maske (104.1),
- einer optischen Elementgruppe (105.2),
- einer Substrateinrichtung (106) zur Aufnahme eines Substrats (106.1) und
- einer Messeinrichtung (113), wobei
- die optische Elementgruppe (105.2) eine Mehrzahl optischer Elemente (107, 108, 109, 110, 111, 112) umfasst und zum Abbilden des Projektionsmusters (104.3) auf dem Substrat (106.1) ausgebildet ist,
- die Messeinrichtung (113) zum Bestimmen wenigstens eines beim Abbilden des Projektionsmusters (104.3) auf dem Substrat (106.1) auftretenden Abbildungsfehlers ausgebildet ist,
- die Messeinrichtung (113) eine Erfassungseinheit (113.1) umfasst,
- die Erfassungseinheit (113.1) zum Erfassen einer durch wenigstens einen Großteil der optischen Elemente (107, 108, 109, 110, 111, 112) der optischen Elementgruppe (105.2) erzeugten Messabbildung wenigstens eines Teils des Projektionsmusters (104.3) und/oder wenigstens eines im Bereich der Maskeneinrichtung (104) angeordneten Messelements (113.2) ausgebildet ist und
- die Messeinrichtung (113) zum Bestimmen des Abbildungsfehlers unter Verwendung der Messabbildung ausgebildet ist,
**dadurch gekennzeichnet, dass**
- die Erfassungseinheit (113.1) derart ausgebildet ist, dass das Erfassen der Messabbildung zeitlich parallel zum Abbilden des Projektionsmusters (104.3) auf dem Substrat (106.1) erfolgt, und
- die Messeinrichtung (113) derart ausgebildet ist, dass das Bestimmen des Abbildungsfehlers zeitlich parallel zum Abbilden des Projektionsmusters (104.3) auf dem Substrat (106.1) erfolgt.

2. Optische Abbildungseinrichtung nach Anspruch 1, **dadurch gekennzeichnet, dass** die Messeinrichtung (113) zum Bestimmen der Abweichung der Position der Abbildung des Projektionsmusters (104.3) auf dem Substrat (106.1) von einer Sollposition als Abbildungsfehler ausgebildet ist.

3. Optische Abbildungseinrichtung nach Anspruch 1 oder 2, **dadurch gekennzeichnet, dass** die Messabbildung durch alle optischen Elemente (107, 108, 109, 110, 111, 112) der optischen Elenlentgruppe (105.2) erzeugt ist.

4. Optische Abbildungseinrichtung nach einem der vorhergehenden Ansprüche,
**dadurch gekennzeichnet, dass**
- die Erfassungseinheit (113.1) zum Erfassen der Messabbildung eines an der Maskeneinrichtung (104) angeordneten Messelements (113.2) ausgebildet ist,
und/oder
- die Erfassungseinheit zum Erfassen der Messabbildung eines in der Nähe des Projektionsmusters (104.3) angeordneten Messelements (113.2) ausgebildet ist.

5. Optische Abbildungseinrichtung nach einem der vorhergehenden Ansprüche,
**dadurch gekennzeichnet, dass**
- die Maskeneinrichtung (104) die Maske (104.1) mit dem Projektionsmuster (104.3) umfasst und
- das Messelement (113.2) an der Maske (104.1) angeordnet ist, wobei
- das Messelement (113.2) Insbesondere unmittelbar benachbart zum Projektionsmuster (104.3) angeordnet ist.

6. Optische Abbitdungseinrichtung nach einem der vorhergehenden Ansprüche,
**dadurch gekennzeichnet, dass**
- das Messelement (113.2) wenigstens ein Messmuster umfasst, wobei
- das Messmuster insbesondere ein zweidimensionales Gitter (113.2) ist und/oder zwei eindimensionale Gitter umfasst.

7. Optische Abbildungseinrichtung nach einem der vorhergehenden Ansprüche,
**dadurch gekennzeichnet, dass**
- die Erfassungseinheit (113.1) im Bereich der Substrateinrichtung (106) angeordnet ist
und/oder
- eine zum Lenken der Messabbildung auf die Erfassungseinheit (113.1) ausgebildete optische Lenkeinrichtung (113.2) im Bereich der Substrateinrichtung (106) vorgesehen ist, wobei insbesondere die Substrateinrichtung (106) das Substrat (106.1) umfasst und die Lenkeinrichtung von einer Oberfläche des Substrats gebildet ist

8. Optische Abbildungseinrichtung nach einem der vorhergehenden Ansprüche, **dadurch gekennzeichnet, dass**
- die Erfassungseinheit (113.1) an einem Referenzelement (105.3) angeordnet ist und
- eine Lagebestimmungseinrichtung (113.6) zur Bestimmung der Lage des Substrats (106.1) bezüglich der Erfassungseinheit (113.1) vorgesehen ist, wobei
- das Referenzelement insbesondere eine Stützstruktur (105.3) für die optische Elementgruppe (105.2) oder ein optisches Element der optischen Elementgruppe ist.

9. Optische Abbildungseinrichtung nach einem der vorhergehenden Ansprüche,
**dadurch gekennzeichnet, dass**.
- zum Abbilden des Projektionsmusters (104.3) auf dem Substrat (106.1) Licht einer ersten Wellenlänge vorgesehen ist und
- zum Generieren der Messabbildung Licht einer zweiten Wellenlänge vorgesehen ist, wobei
- die erste Wellenlänge von der zweiten Wellenlänge verschieden ist, wobei
- die zweite Wellenlänge insbesondere hinsichtlich einer Optimierung der Empfindlichkeit der Erfassungseinheit (113.1) an die Erfassungseinheit (113.1) angepasst ist.

10. Optische Abbildungseinrichtung nach Anspruch 9, **dadurch gekennzeichnet, dass** die erste Wellenlänge im EUV-Bereich, insbesondere im Bereich von 13 nm, liegt.

11. Optische Abbildungseinrichtung nach einem der vorhergehenden Ansprüche, **dadurch gekennzeichnet, dass**
- eine mit der Erfassungseinheit (113.1) verbundene Korrektureinrichtung (115) vorgesehen ist,
- wenigstens eine der an der Abbildung des Projektionsmusters auf dem Substrat beteiligten Komponenten (104, 106, 107, 108,109, 110, 111, 112) der Abbildungseinrichtung (101) eine aktiv steuerbare Komponente (112) ist,
- die aktiv steuerbare Komponente (112) mit der Korrektureinrichtung (115) verbindbar ist und
- zur zumindest teilweisen Korrektur des Abbildungsfehlers die Korrektureinrichtung (15) zum Ansteuern der aktiv steuerbaren Komponente (112) in Abhängigkeit von dem Abbildungsfehler ausgebildet ist, wobei
- die wenigstens eine aktiv steuerbare Komponente insbesondere eine Komponente der Maskeneinrichtung (104), ein optisches Element (112) der optischen Elementgruppe (105.2) oder eine Komponente der Substrateinrichtung (104) ist.

12. Abbildungsverfahren, insbesondere für die Mikrolithographie, bei dem
- ein Projektionsmuster (104.3) mittels der optischen Elemente (107, 108, 109, 110, 111, 112) einer optischen Elementgruppe (105.2) auf ein Substrat (106.1) abgebildet wird und
- eine Bestimmung wenigstens eines beim Abbilden des Projektionsmusters (104.3) auf dem Substrat (106.1) auftretenden Abbildungsfehlers erfolgt, wobei
- eine durch wenigstens einen Großteil der optischen Elemente (107, 108, 109, 110, 111, 112) der optischen Elementgruppe (105.2) erzeugte Messabbildung wenigstens eines Teils des Projektionsmusters (104.3) und/oder wenigstens eines im Bereich des Projektionsmusters (104.3) angeordneten Messelements (113.2) erfasst wird und
- die Bestimmung des Abbildungsfehlers unter Verwendung der Messabbildung erfolgt,
**dadurch gekennzeichnet, dass**
- das Erfassen der Messabbildung und die Bestimmung des Abbildungsfehlers zeitlich parallel zum Abbilden des Projektionsmusters (104.3) auf dem Substrat (106.1) erfolgt.

13. Abbildungsverfahren nach Anspruch 12, **dadurch gekennzeichnet, dass** die Abweichung der Position der Abbildung des Projektionsmusters (104.3) auf dem Substrat (106.1) von einer Sollposition als Abbildungsfehler bestimmt wird.

14. Abbildungsverfahren nach Anspruch 12 oder 13, **dadurch gekennzeichnet, dass** die Messabbildung durch alle optischen Elemente (107, 108, 109, 110, 111, 112) der optischen Elementgruppe (105.2) erzeugt wird.

15. Abbildungsverfahren nach einem der Ansprüche 12 bis 14, **dadurch gekennzeichnet, dass**
- das Messelement (113.2) an einer das Projektionsmuster (104.3) umfassenden Maskeneinrichtung (104) angeordnet ist
und/oder
- das Messelement (113.2) in der Nähe des Projektionsmusters angeordnet ist.

16. Abbildungsverfahren nach einem der Ansprüche 12 bis 15, **dadurch gekennzeichnet, dass**
- das Messelement (113.2) an einer das Projektionsmuster (104.3) umfassenden Maske (104.1) angeordnet ist, wobei
- das Messelement (113.2) insbesondere unmittelbar benachbart zum Projektionsmuster (104.3) angeordnet ist

17. Abbildungsverfahren nach einem der Ansprüche 12 bis 16, **dadurch gekennzeichnet, dass**
- das Messelement (113.2) wenigstens ein Messmuster umfasst, wobei
- das Messmuster insbesondere ein zweidimensionales Gitter (113.2) ist und/oder zwei eindimensionale Gitter umfasst.

18. Abbildungsverfahren nach einem der Ansprüche 12 bis 17, **dadurch gekennzeichnet, dass** die Messabbildung
- im Bereich des Substrats (106.1) erfasst wird
und/oder
- unter Verwendung einer im Bereich des Substrats (106.1) angeordneten optischen Lenkeinrichtung (113.2) erfasst wird, wobei die Lenkeinrichtung insbesondere von einer Oberfläche des Substrats (106.1) gebildet ist.

19. Abbildungsverfahren nach einem der Ansprüche 12 bis 18, **dadurch gekennzeichnet, dass**
- die Messabbildung über eine an einem Referenzelement (105.3) angeordnet Erfassungseinheit (113.1) erfasst wird und
- die Lage des Substrats (106.1) bezüglich der Erfassungseinheit (113.1) bestimmt wird, wobei
- das Referenzelement insbesondere eine Stützstruktur (105.3) für die optische Elementgruppe (105.2) oder ein optisches Element der optischen Elementgruppe (105.2) ist.

20. Abbildungsverfahren nach einem der Ansprüche 12 bis 19, **dadurch gekennzeichnet, dass**.
- das Projektionsmuster (104.3) auf dem Substrat (106.1) mit Licht einer ersten Wellenlänge abgebildet wird und
- die Messabbildung mit Licht einer zweiten Wellenlänge generiert wird, wobei
- die erste Wellenlänge von der zweiten Wellenlänge verschieden ist, wobei
- die zweite Wellenlänge insbesondere hinsichtlich einer Optimierung der Empfindlichkeit bei der Erfassung der Messabbildung angepasst ist.

21. Abbildungsverfahren nach einem der Ansprüche 12 bis 20, **dadurch gekennzeichnet, dass**
- wenigstens eine der an der Abbildung des Projektionsmusters auf dem Substrat beteiligten Komponenten (104, 106, 107, 108, 109, 110, 111, 112) eine aktiv steuerbare Komponente (112) ist und
- zur zumindest teilweisen Korrektur des Abbildungsfehlers die aktiv steuerbare Komponente (112) in Abhängigkeit von dem Abbildungsfehler angesteuert wird, wobei
- die wenigstens eine aktiv steuerbare Komponente (112) insbesondere eine Komponente einer das Projektionsmuster (104.3) umfassenden Maskeneinrichtung (104), ein optisches Element (112) der optischen Elementgruppe (105.2) oder eine Komponente einer das Substrat (106.1) umfassenden Substrateinrichtung (106) ist.

22. Optische Abbildungseinrichtung nach Anspruch 1, mit
- der das Projektionsmuster (104.3) umfassenden Maske (104.1) und
- dem Substrat (106.1), wobei
- die Messabbildung weiterhin durch wenigstens ein mit einem der ersten optischen Elemente (107, 108, 109, 110, 111, 112) in Wirkverbindung stehendes zweites optisches Element erzeugt wird.

23. Optische Abbildungseinrichtung, insbesondere für die Mikrolithographie, mit
- einer Maskeneinrichtung (104) zur Aufnahme einer ein Projektionsmuster (104.3) umfassenden Maske (104.1),
- einer optischen Elementgruppe (105.2),
- einer Substrateinrichtung (106) zur Aufnahme eines Substrats (106.1) und
- einer Messeinrichtung (113), wobei
- die optische Elementgruppe (105.2) eine Mehrzahl optischer Elemente (107, 108, 109, 110, 111, 112) umfasst und zum Abbilden des Projektionsmusters (104.3) auf dem Substrat (106.1) ausgebildet ist,
- die Messeinrichtung (113) zum Bestimmen wenigstens eines beim Abbilden des Projektionsmusters (104.3) auf dem Substrat (106.1) auftretenden Abbildungsfehlers ausgebildet ist,
- die Messeinrichtung (113) eine Erfassungseinheit (113.1) umfasst,
- die Erfassungseinheit (113.1) zum Erfassen einer Messabbildung wenigstens eines Teils des Projektionsmusters (104.3) und/oder wenigstens eines im Bereich der Maskeneinrichtung (104) angeordneten Messelements (113.2) ausgebildet ist und
- die Messeinrichtung (113) zum Bestimmen des Abbildungsfehlers unter Verwendung der Messabbildung ausgebildet ist,
**dadurch gekennzeichnet, dass**
- die Messeinrichtung (113) eine Mehrzahl von zweiten optischen Elementen umfasst, die jeweils mit einem der ersten optischen Elemente (107, 108, 109, 110, 111, 112) in Wirkverbindung stehen,
- die Messabbildung durch die zweiten optischen Elemente erzeugt wird,
- die Erfassungseinheit (113.1) derart ausgebildet ist, dass das Erfassen der Messabbildung zeitlich parallel zum Abbilden des Projektionsmusters (104.3) auf dem Substrat (106.1) erfolgt, und
- die Messeinrichtung (113) derart ausgebildet ist, dass das Bestimmen des Abbildungsfehlers zeitlich parallel zum Abbilden des Projektionsmusters (104.3) auf dem Substrat (106.1) erfolgt.

24. Optische Abbildungseinrichtung nach Anspruch 22 oder 23, **dadurch gekennzeichnet, dass**
- eine mit der Erfassungseinheit (113.1) verbundene Korrektureinrichtung (115) vorgesehen ist,
- wenigstens eine der an der Abbildung des Projektionsmusters auf dem Substrat beteiligten Komponenten (104, 106, 107, 108, 109, 110, 111, 112) der Abbildungseinrichtung (101) eine aktiv steuerbare Komponente (112) ist,
- die aktiv steuerbare Komponente (112) mit der Korrektureinrichtung (115) verbindbar ist und
- die aktiv steuerbare Komponente (112) zur zumindest teilweisen Korrektur des Abbildungsfehlers in Abhängigkeit von dem erfassten Abbildungsfehler durch die Korrektureinrichtung (115) ansteuerbar ist

25. Abbildungsverfahren nach Anspruch 12, bei dem
- das Projektionsmuster (104.3) mittels eines Projektionslichtbündels und mittels erster optischer Elemente (107, 108, 109, 110, 111, 112) der optischen Elementgruppe (105.2) auf das Substrat (106.1) abgebildet wird, wobei
- die Messabbildung weiterhin durch wenigstens ein mit einem der ersten optischen Elemente (107, 108, 109, 110, 111, 112) in Wirkverbindung stehendes zweites optisches Element erzeugt wird.

26. Abbildungsverfahren, insbesondere für die Mikrolithographie, bei dem
- ein Projektionsmuster (104.3) mittels der optischen Elemente (107, 108, 109, 110, 111, 112) einer optischen Elementgruppe (105.2) auf ein Substrat (106.1) abgebildet wird und
- eine Bestimmung wenigstens eines beim Abbilden des Projektionsmusters (104.3) auf dem Substrat (106.1) auftretenden Abbildungsfehlers erfolgt, wobei
- eine Messabbildung wenigstens eines Teils des Projektionsmusters (104.3) und/oder wenigstens eines im Bereich des Projektionsmusters (104.3) angeordneten Messelements (113.2) erfasst wird und
- die Bestimmung des Abbildungsfehlers unter Verwendung der Messabbildung erfolgt,
**dadurch gekennzeichnet, dass**
- die Messabbildung durch ein Messlichtbündel und eine Mehrzahl von zweiten optischen Elementen, die jeweils mit einem der optischen Elemente (107, 108, 109, 110, 111, 112) der optischen Elementgruppe (105.2) in Wirkverbindung stehen, erzeugt wird,
- das Erfassen der Messabbildung und die Bestimmung des Abbildungsfehlers zeitlich parallel zum Abbilden des Projektionsmusters (104.3) auf dem Substrat (106.1) erfolgt.

27. Abbildungsverfahren nach Anspruch 25 oder 26, **dadurch gekennzeichnet, dass**
- wenigstens eine der an der Abbildung des Projektionsmusters auf dem Substrat beteiligten Komponenten (104, 106, 107, 108, 109, 110, 111, 112) eine aktiv steuerbare Komponente (112) ist und
- zur zumindest teilweisen Korrektur des Abbildungsfehlers die aktiv steuerbare Komponente (112) In Abhängigkeit von dem Abbildungsfehler angesteuert wird.

## Claims

1. Optical image device, more particularly for microlithography, comprising
- a mask device (104) for holding a mask (104.1) comprising a projection pattern (104.3),
- an optical element group (105.2),
- a substrate device (106) for holding a substrate (106.1) and
- a measuring device (113), wherein
- the optical element group (105.2) comprises a plurality of optical elements (107, 108, 109, 110, 111, 112) and is configured for imaging the projection pattern (104.3) on the substrate (106.1),
- the measuring device (113) is embodied for determining at least one aberration occurring when the projection pattern (104.3) is imaged on the substrate (106.1),
- the measuring device (113) comprises an acquisition unit (113.1),
- the acquisition unit (113.1) is embodied for acquiring a measurement image, generated by at least a majority of the optical elements (107, 108, 109, 110, 111, 112) of the optical element group (105.2), of at least part of the projection pattern (104.3) and/or at least one measurement element (113.2) arranged in the region of the mask device (104) and
- the measuring device (113) is embodied for determining the aberration using the measurement image,
**characterized in that**
- the acquisition unit (113.1) is embodied in such a way that the acquisition of the measurement image occurs parallel in time with the imaging of the projection pattern (104.3) on the substrate (106.1) and
- the measuring device (113) is embodied in such a way that the determination of the aberration occurs parallel in time with the imaging of the projection pattern (104.3) on the substrate (106.1).

2. Optical imaging device according to Claim 1, **characterized in that** the measuring device (113) is embodied to determine the deviation from an intended position of the position of the image of the projection pattern (104.3) on the substrate (106.1) as the aberration.

3. Optical imaging device according to Claim 1 or 2, **characterized in that** the measurement image is generated by all optical elements (107, 108, 109, 110, 111, 112) of the optical element group (105.2).

4. Optical imaging device according to one of the preceding claims, **characterized in that**
- the acquisition unit (113.1) is embodied to acquire the measurement image of a measurement element (113.2) arranged at the mask device (104)
and/or
- the acquisition unit is embodied to acquire the measurement image of measurement element (113.2) arranged in the vicinity of the projection pattern (104.3).

5. Optical imaging device according to one of the preceding claims, **characterized in that**
- the mask device (104) comprises the mask (104.1) comprising the projection pattern (104.3) and
- the measurement element (113.2) is arranged at the mask (104.1), wherein
- the measurement element (113.2) is, in particular, arranged directly adjacent to the projection pattern (104.3).

6. Optical imaging device according to one of the preceding claims, **characterized in that**
- the measurement element (113.2) comprises at least one measurement pattern, wherein
- the measurement pattern is, in particular, a two-dimensional grid (113.2) and/or comprises two one-dimensional grids.

7. Optical imaging device according to one of the preceding claims, **characterized in that**
- the acquisition unit (113.1) is arranged in the region of the substrate device (106)
and/or
- an optical guide device (113.2) embodied for guiding the measurement image onto the acquisition unit (113.1) is provided in the region of the substrate device (106), wherein, in particular, the substrate device (106) comprises the substrate (106.1) and the guide device is formed by a surface of the substrate.

8. Optical imaging device according to one of the preceding claims, **characterized in that**
- the acquisition unit (113.1) is arranged at a reference element (105.3) and
- provision is made for a location determination device (113.6) for determining the location of the substrate (106.1) in relation to the acquisition unit (113.1), wherein
- the reference element is, in particular, a support structure (105.3) for the optical element group (105.2) or an optical element of the optical element group.

9. Optical imaging device according to one of the preceding claims, **characterized in that**
- light of a first wavelength is provided for imaging the projection pattern (104.3) on the substrate (106.1) and
- light of a second wavelength is provided for generating the measurement image, wherein
- the first wavelength differs from the second wavelength, wherein
- the second wavelength is, in particular, adapted to the acquisition unit (113.1) in respect of an optimization of the sensitivity of the acquisition unit (113.1).

10. Optical imaging device according to Claim 9, **characterized in that** the first wavelength lies in the EUV range, in particular in the region of 13 nm.

11. Optical imaging device according to one of the preceding claims, **characterized in that**
- provision is made for a correction device (115) connected to the acquisition unit (113.1),
- at least one of the components (104, 106, 107, 108, 109, 110, 111, 112) of the imaging device (101) involved in the imaging of the projection pattern on the substrate is an actively controllable component (112),
- the actively controllable component (112) is connectable to the correction device (115), and
- the correction device (115) is embodied for actuating the actively controllable component (112) depending on the aberration in order to at least partly correct the aberration, wherein
- the at least one actively controllable component is, in particular, a component of the mask device (104), an optical element (112) of the optical element group (105.2) or a component of the substrate device (106).

12. Imaging method, more particularly for microlithography, in which
- a projection pattern (104.3) is imaged on a substrate (106.1) by means of the optical elements (107, 108, 109, 110, 111, 112) of an optical element group (105.2) and
- at least one aberration occurring when imaging the projection pattern (104.3) on the substrate (106.1) is determined, wherein
- a measurement image, generated by at least a majority of the optical elements (107, 108, 109, 110, 111, 112) of the optical element group (105.2), of at least part of the projection pattern (104.3) and/or at least one measurement element (113.2) arranged in the region of the projection pattern (104.3) is acquired and
- the aberration is determined using the measurement image,
**characterized in that**
- the acquisition of the measurement image and the determination of the aberration occurs parallel in time with the imaging of the projection pattern (104.3) on the substrate (106.1).

13. Imaging method according to Claim 12, **characterized in that** the deviation from an intended position of the position of the image of the projection pattern (104.3) on the substrate (106.1) is determined as aberration.

14. Imaging method according to Claim 12 or 13, **characterized in that** the measurement image is generated by all optical elements (107, 108, 109, 110, 111, 112) of the optical element group (105.2).

15. Imaging method according to one of Claims 12 to 14, **characterized in that**
- the measurement element (113.2) is arranged at a mask device (104) comprising the projection pattern (104.3)
and/or
- the measurement element (113.2) is arranged in the vicinity of the projection pattern.

16. Imaging method according to one of Claims 12 to 15, **characterized in that**
- the measurement element (113.2) is arranged at a mask (104.1) comprising the projection pattern (104.3), wherein
- the measurement element (113.2) is, in particular, arranged directly adjacent to the projection pattern (104.3).

17. Imaging method according to one of Claims 12 to 16, **characterized in that**
- the measurement element (113.2) comprises at least one measurement pattern, wherein
- the measurement pattern is, in particular, a two-dimensional grid (113.2) and/or comprises two one-dimensional grids.

18. Imaging method according to one of Claims 12 to 17, **characterized in that** the measurement image
- is acquired in the region of the substrate (106.1)
and/or
- is acquired using an optical guide device (113.2) arranged in the region of the substrate (106.1), wherein the guide device is, in particular, formed by a surface of the substrate (106.1).

19. Imaging method according to one of Claims 12 to 18, **characterized in that**
- the measurement image is acquired by means of an acquisition unit (113.1) arranged at a reference element (105.3) and
- the location of the substrate (106.1) is determined in relation to the acquisition unit (113.1), wherein
- the reference element is, in particular, a support structure (105.3) for the optical element group (105.2) or an optical element of the optical element group (105.2).

20. Imaging method according to one of Claims 12 to 19, **characterized in that**
- the projection pattern (104.3) on the substrate (106.1) is imaged by light of a first wavelength and
- the measurement image is generated by light of a second wavelength, wherein
- the first wavelength differs from the second wavelength, wherein
- the second wavelength is, in particular, adapted in respect of an optimization of the sensitivity when acquiring the measurement image.

21. Imaging method according to one of Claims 12 to 20, **characterized in that**
- at least one of the components (104, 106, 107, 108, 109, 110, 111, 112) involved in the imaging of the projection pattern on the substrate is an actively controllable component (112) and
- the actively controllable component (112) is actuated depending on the aberration in order to at least partly correct the aberration, wherein
- the at least one actively controllable component (112) is, in particular, a component of a mask device (104) comprising the projection pattern (104.3), an optical element (112) of the optical element group (105.2) or a component of a substrate device (106) comprising the substrate (106.1).

22. Optical imaging device according to Claim 1, comprising
- the mask (104.1) comprising the projection pattern (104.3) and
- the substrate (106.1), wherein
- the measurement image is furthermore generated by at least one second optical element which has a functional connection with one of the first optical elements (107, 108, 109, 110, 111, 112).

23. Optical image device, more particularly for microlithography, comprising
- a mask device (104) for holding a mask (104.1) comprising a projection pattern (104.3),
- an optical element group (105.2),
- a substrate device (106) for holding a substrate (106.1) and
- a measuring device (113), wherein
- the optical element group (105.2) comprises a plurality of optical elements (107, 108, 109, 110, 111, 112) and is configured for imaging the projection pattern (104.3) on the substrate (106.1),
- the measuring device (113) is embodied for determining at least one aberration occurring when the projection pattern (104.3) is imaged on the substrate (106.1),
- the measuring device (113) comprises an acquisition unit (113.1),
- the acquisition unit (113.1) is embodied for acquiring a measurement image of at least part of the projection pattern (104.3) and/or at least one measurement element (113.2) arranged in the region of the mask device (104) and
- the measuring device (113) is embodied for determining the aberration using the measurement image,
**characterized in that**
- the measuring device (113) comprises a plurality of second optical elements which respectively have a functional connection with one of the first optical elements (107, 108, 109, 110, 111, 112),
- the measurement image is generated by the second optical elements,
- the acquisition unit (113.1) is embodied in such a way that the acquisition of the measurement image occurs parallel in time with the imaging of the projection pattern (104.3) on the substrate (106.1) and
- the measuring device (113) is embodied in such a way that the determination of the aberration occurs parallel in time with the imaging of the projection pattern (104.3) on the substrate (106.1).

24. Optical imaging device according to Claim 22 or 23, **characterized in that**
- provision is made for a correction device (115) connected to the acquisition unit (113.1),
- at least one of the components (104, 106, 107, 108, 109, 110, 111, 112) of the imaging device (101) involved in the imaging of the projection pattern on the substrate is an actively controllable component (112),
- the actively controllable component (112) is connectable to the correction device (115), and
- the actively controllable component (112) is actuatable by the correction device (115) in order to, depending on the acquired aberration, at least partly correct the aberration.

25. Imaging device according to Claim 12, in which
- the projection pattern (104.3) is imaged on the substrate (106.1) by means of a projection light beam and by means of first optical elements (107, 108, 109, 110, 111, 112) of the optical element group (105.2), wherein
- the measurement image is furthermore generated by at least one second optical element which has a functional connection with one of the first optical elements (107, 108, 109, 110, 111, 112).

26. Imaging method, more particularly for microlithography, in which
- a projection pattern (104.3) is imaged on a substrate (106.1) by means of the optical elements (107, 108, 109, 110, 111, 112) of an optical element group (105.2) and
- at least one aberration occurring when imaging the projection pattern (104.3) on the substrate (106.1) is determined, wherein
- a measurement image of at least part of the projection pattern (104.3) and/or at least one measurement element (113.2) arranged in the region of the projection pattern (104.3) is acquired and
- the aberration is determined using the measurement image,
**characterized in that**
- the measurement image is generated by a measurement light beam and a plurality of second optical elements which respectively have a functional connection with one of the optical elements (107, 108, 109, 110, 111, 112) of the optical element group (105.2),
- the acquisition of the measurement image and the determination of the aberration occurs parallel in time with the imaging of the projection pattern (104.3) on the substrate (106.1).

27. Imaging method according to Claim 25 or 26, **characterized in that**
- at least one of the components (104, 106, 107, 108, 109, 110, 111, 112) involved in the imaging of the projection pattern on the substrate is an actively controllable component (112) and
- the actively controllable component (112) is actuated depending on the aberration in order to at least partly correct the aberration.

## Revendications

1. Dispositif d'imagerie optique, notamment pour la microlithographie, comportant
- un dispositif pour masques (104) destiné à recevoir un masque (104.1) comprenant un motif de projection (104.3),
- un groupe d'éléments optiques (105.2),
- un dispositif pour substrat (106) destiné à recevoir un substrat (106.1) et
- un dispositif de mesure (113), dans lequel
- le groupe d'éléments optiques (105.2) comprend une pluralité d'éléments optiques (107, 108, 109, 110, 111, 112) et est conçu pour former l'image du motif de projection (104.3) sur le substrat (106.1),
- le dispositif de mesure (113) est conçu pour déterminer au moins un défaut de formation d'image se produisant lors de la formation d'image du motif de projection (104.3) sur le substrat (106.1),
- le dispositif de mesure (113) comprend une unité de détection (113.1),
- l'unité de détection (113.1) est conçue pour détecter une image de mesure générée par au moins une grande partie des éléments optiques (107, 108, 109, 110, 111, 112) du groupe d'éléments optiques (105.2) d'au moins une partie du motif de projection (104.3) et/ou d'au moins un élément de mesure (113.2) disposé dans la région du dispositif pour masques (104) et
- le dispositif de mesure (113) est conçu pour déterminer le défaut de formation d'image par utilisation de l'image de mesure,
**caractérisé en ce que**
- l'unité de détection (113.1) est conçue de manière à ce que la détection de l'image de mesure s'effectue en parallèle dans le temps avec la formation d'image du motif de projection (104.3) formée sur le substrat (106.1), et
- le dispositif de mesure (113) est conçu de manière à ce que la détermination du défaut de formation d'image s'effectue en parallèle dans le temps avec la formation d'image du motif de projection (104.3) formée sur le substrat (106.1).

2. Dispositif d'imagerie optique selon la revendication 1, **caractérisé en ce que** le dispositif de mesure (113) est conçu pour déterminer l'écart de position de l'image du motif de projection (104.3) formée sur le substrat (106.1) par rapport à une position nominale en tant que défaut de formation d'image.

3. Dispositif d'imagerie optique selon la revendication 1 ou 2, **caractérisé en ce que** l'image de mesure est générée par la totalité des éléments optiques (107, 108, 109, 110, 111, 112) du groupe d'éléments optiques (105.2).

4. Dispositif d'imagerie optique selon l'une quelconque des revendications précédentes, **caractérisé en ce que**
- l'unité de détection (113.1) est conçue pour détecter l'image de mesure d'un élément de mesure (113.2) disposé sur le dispositif pour masques (104),
et/ou
- l'unité de détection est conçue pour détecter l'image de mesure d'un élément de mesure (113.2) disposé à proximité du motif de projection (104.3).

5. Dispositif d'imagerie optique selon l'une quelconque des revendications précédentes, **caractérisé en ce que**
- le dispositif pour masques (104) comprend le masque (104.1) avec le motif de projection (104.3), et
- l'élément de mesure (113.2) est disposé sur le masque (104.1), dans lequel
- l'élément de mesure (113.2) est notamment disposé de manière immédiatement adjacente au motif de projection (104.3).

6. Dispositif d'imagerie optique selon l'une quelconque des revendications précédentes, **caractérisé en ce que**
- l'élément de mesure (113.2) comprend au moins un motif de mesure, dans lequel
- le motif de mesure est notamment une grille bidimensionnelle (113.2) et/ou comprend une grille bidimensionnelle.

7. Dispositif d'imagerie optique selon l'une quelconque des revendications précédentes, **caractérisé en ce que**
- l'unité de détection (113.1) est disposée dans la région du dispositif pour substrat (106),
et/ou
- un dispositif de déviation optique (113.2) conçu pour dévier l'image de mesure formée sur l'unité de détection (113.1) est prévu dans la région du dispositif pour substrat (106), dans lequel le dispositif pour substrat (106) comprend notamment le substrat (106.1) et le dispositif de déviation est constitué par une surface du substrat.

8. Dispositif d'imagerie optique selon l'une quelconque des revendications précédentes, **caractérisé en ce que**
- l'unité de détection (113.1) est disposée sur un élément de référence (105.3) et
- un dispositif de détermination de position (113.6) est prévu pour déterminer la position du substrat (106.1) par rapport à l'unité de détection (113.1), dans lequel
- l'élément de référence est notamment une structure de support (105.3) pour le groupe d'éléments optiques (105.2) ou un élément optique du groupe d'éléments optiques.

9. Dispositif d'imagerie optique selon l'une quelconque des revendications précédentes, **caractérisé en ce que**
- une lumière ayant une première longueur d'onde est prévue pour la formation d'image du motif de projection (104.3) sur le substrat (106.1) et
- une lumière ayant une seconde longueur d'onde est prévue pour générer l'image de mesure, dans lequel
- la première longueur d'onde est différente de la seconde longueur d'onde, dans lequel
- la seconde longueur d'onde est adaptée à l'unité de détection (113.1) notamment en ce qui concerne une optimisation de la sensibilité de l'unité de détection (113.1).

10. Dispositif d'imagerie optique selon la revendication 9, **caractérisé en ce que** la première longueur d'onde se situe dans la région EUV, notamment dans une région de 13 nm.

11. Dispositif d'imagerie optique selon l'une quelconque des revendications précédentes, **caractérisé en ce que**
- il est prévu un dispositif de correction (115) connecté à l'unité de détection (113.1),
- au moins l'un des composants (104, 106, 107, 108, 109, 110, 111, 112) du dispositif d'imagerie (101) participant à la formation d'image du motif de projection sur le substrat est un composant actif pouvant être commandé (112),
- le composant actif pouvant être commandé (112) peut être connecté au dispositif de correction (115) et
- le dispositif de correction (115) est conçu pour commander le composant actif pouvant être commandé (112) en fonction du défaut de formation d'image pour corriger au moins partiellement le défaut de formation d'image, dans lequel
- l'au moins un composant actif pouvant être commandé est un composant du dispositif pour masques (104), un élément optique (112) du groupe d'éléments optiques (105.2) ou un composant du dispositif pour substrat (104).

12. Procédé d'imagerie, notamment pour la microlithographie, dans lequel
- un motif de projection (104.3) est soumis à une formation d'image au moyen des éléments optiques (107, 108, 109, 110, 111, 112) d'un groupe d'éléments optiques (105.2) sur un substrat (106.1) et
- une détermination d'au moins un défaut de formation d'image apparaissant lors de la formation d'image du motif de projection (104.3) sur le substrat (106.1) est effectuée, dans lequel
- une image de mesure générée par au moins une grande partie des éléments optiques (107, 108, 109, 110, 111, 112) du groupe d'éléments optiques (105.2) d'au moins une partie du motif de projection (104.3) et/ou d'au moins un élément de mesure (113.2) disposé dans la région du motif de projection (104.3) est détectée et
- la détermination du défaut de formation d'image est effectuée par utilisation de l'image de mesure, **caractérisé en ce que**
- la détection de l'image de mesure et la détermination du défaut de formation d'image s'effectuent en parallèle dans le temps avec la formation d'image du motif de projection (104.3) sur le substrat (106.1).

13. Procédé d'imagerie selon la revendication 12, **caractérisé en ce que** l'écart de position de l'image du motif de projection (104.3) sur le substrat (106.1) par rapport à une position nominale est déterminé en tant que défaut de formation d'image.

14. Procédé d'imagerie selon la revendication 12 ou 13, **caractérisé en ce que** l'image de mesure est générée par la totalité des éléments optiques (107, 108, 109, 110, 111, 112) du groupe d'éléments optiques (105.2).

15. Procédé d'imagerie selon l'une quelconque des revendications 12 à 14, **caractérisé en ce que**
- l'élément de mesure (113.2) est disposé sur un dispositif pour masques (104) comprenant le motif de projection (104.3)
et/ou
- l'élément de mesure (113.2) est disposé à proximité du motif de projection.

16. Procédé d'imagerie selon l'une quelconque des revendications 12 à 15, **caractérisé en ce que**
- l'élément de mesure (113.2) est disposé sur un masque (104.1) comprenant le motif de projection (104.3), dans lequel
- l'élément de mesure (113.2) est notamment disposé de manière immédiatement adjacente au motif de projection (104.3).

17. Procédé d'imagerie selon l'une quelconque des revendications 12 à 16, **caractérisé en ce que**
- l'élément de mesure (113.2) comprend au moins un motif de mesure, dans lequel
- le motif de mesure est notamment une grille bidimensionnelle (113.2) et/ou comprend une grille bidimensionnelle.

18. Procédé d'imagerie selon l'une quelconque des revendications 12 à 17, **caractérisé en ce que** l'image de mesure
- est détectée dans la région du substrat (106.1) et/ou
- est détectée par utilisation d'un dispositif de déviation optique (113.2) disposé dans la région du substrat (106.1), dans lequel le dispositif de déviation est notamment formé par une surface du substrat (106.1).

19. Procédé d'imagerie selon l'une quelconque des revendications 12 à 18, **caractérisé en ce que**
- l'image de mesure est détectée par l'intermédiaire d'une unité de détection (113.1) disposée sur un élément de référence (105.3) et
- la position du substrat (106.1) par rapport à l'unité de détection (113.1) est déterminée, dans lequel
- l'élément de référence est notamment une structure de support (105.3) pour le groupe d'éléments optiques (105.2) ou un élément optique du groupe d'éléments optiques (105.2).

20. Procédé d'imagerie selon l'une quelconque des revendications 12 à 19, **caractérisé en ce que**
- le motif de projection (104.3) est soumis à une formation d'image sur le substrat (106.1) avec une lumière ayant une première longueur d'onde et
- l'image de mesure est générée avec une lumière ayant une seconde longueur d'onde, dans lequel
- la première longueur d'onde est différente de la seconde longueur d'onde, dans lequel
- la seconde longueur d'onde est adaptée à l'image de mesure notamment en ce qui concerne une optimisation de la sensibilité de détection.

21. Procédé d'imagerie selon l'une quelconque des revendications 12 à 20, **caractérisé en ce que**
- au moins l'un des composants (104, 106, 107, 108, 109, 110, 111, 112) participant à la formation d'image du motif de projection sur le substrat est un composant actif pouvant être commandé (112) et
- le composant actif pouvant être commandé (112) est commandé en fonction du défaut de formation d'image pour corriger au moins partiellement le défaut de formation d'image, dans lequel
- l'au moins un composant actif pouvant être commandé (112) est notamment un composant d'un dispositif pour masques (104) comprenant le motif de projection (104.3), un élément optique (112) du groupe d'éléments optiques (105.2) ou un composant d'un dispositif pour substrat (106) comprenant le substrat (106.1).

22. Dispositif d'imagerie selon la revendication 1, comportant
- le masque (104.1) comprenant le motif de projection (104.3) et
- le substrat (106.1), dans lequel
- l'image de mesure est en outre générée par au moins un second élément optique en liaison fonctionnelle avec l'un des premiers éléments optiques (107, 108, 109, 110, 111, 112).

23. Dispositif d'imagerie optique, notamment pour la microlithographie, comportant
- un dispositif pour masques (104) destiné à recevoir un masque (104.1) comprenant un motif de projection (104.3),
- un groupe d'éléments optiques (105.2),
- un dispositif pour substrat (106) destiné à recevoir un substrat (106.1) et
- un dispositif de mesure (113), dans lequel
- le groupe d'éléments optiques (105.2) comprend une pluralité d'éléments optiques (107, 108, 109, 110, 111, 112) et est conçu pour former l'image du motif de projection (104.3) sur le substrat (106.1),
- le dispositif de mesure (113) est conçu pour déterminer au moins un défaut de formation d'image se produisant lors de la formation d'image du motif de projection (104.3) sur le substrat (106.1),
- le dispositif de mesure (113) comprend une unité de détection (113.1),
- l'unité de détection (113.1) est conçue pour détecter une image de mesure d'au moins une partie du motif de projection (104.3) et/ou d'au moins un élément de mesure (113.2) disposé dans la région du dispositif pour masques (104), et
- le dispositif de mesure (113) est conçu pour déterminer le défaut de formation d'image par utilisation de l'image de mesure,
**caractérisé en ce que**
- le dispositif de mesure (113) comprend une pluralité de seconds éléments optiques qui sont respectivement en liaison fonctionnelle avec les premiers éléments optiques (107, 108, 109, 110, 111, 112),
- l'image de mesure est générée par les seconds éléments optiques,
- l'unité de détection (113.1) est conçue de manière à ce que la détection de l'image de mesure s'effectue en parallèle dans le temps avec la formation d'image du motif de projection (104.3) sur le substrat (106.1), et
- le dispositif de mesure (113) est conçu de manière à ce que la détermination du défaut de formation d'image s'effectue en parallèle dans le temps avec la formation d'image du motif de projection (104.3) sur le substrat (106.1).

24. Dispositif d'imagerie selon la revendication 22 ou 23, **caractérisé en ce que**
- il est prévu un dispositif de correction (115) connecté à l'unité de détection (113.1),
- au moins l'un des composants (104, 106, 107, 108, 109, 110, 111, 112) du dispositif d'imagerie (101) participant à la formation d'image du motif de projection sur le substrat est un composant actif pouvant être commandé (112),
- le composant actif pouvant être commandé (112) peut être connecté au dispositif de correction (115) et
- le composant actif pouvant être commandé (112) peut être commandé en fonction du défaut de formation d'image détecté par le dispositif de correction (115) pour corriger au moins partiellement le défaut de formation d'image.

25. Procédé d'imagerie selon la revendication 12, dans lequel
- l'image du motif de projection (104.3) est formée au moyen d'un faisceau de projection et au moyen d'un premier élément optique (107, 108, 109, 110, 111, 112) du groupe d'éléments optiques (105.2) sur le substrat (106.1), dans lequel
- l'image de mesure est en outre générée par au moins un second élément optique en liaison fonctionnelle avec l'un des premiers éléments optiques (107, 108, 109, 110, 111, 112).

26. Procédé d'imagerie, notamment pour la microlithographie, dans lequel
- l'image d'un motif de projection (104.3) est formée au moyen des éléments optiques (107, 108, 109, 110, 111, 112) d'un groupe d'éléments optiques (105.2) sur un substrat (106.1) et
- une détermination d'au moins un défaut de formation d'image se produisant lors de la formation d'image du motif de projection (104.3) sur le substrat (106.1) est effectuée, dans lequel
- une image de mesure d'au moins une partie du motif de projection (104.3) et/ou d'au moins un élément de mesure (113.2) disposé dans la région du motif de projection (104.3) est détectée et
- la détermination du défaut de formation d'image s'effectue par utilisation de l'image de mesure, **caractérisé en ce que**
- l'image de mesure est générée au moyen d'un faisceau de lumière de mesure et d'une pluralité de seconds éléments optiques qui sont en liaison fonctionnelle avec l'un des éléments optiques (107, 108, 109, 110, 111, 112) du groupe d'éléments optiques (105.2),
- la détection de l'image de mesure et la détermination du défaut de formation d'image s'effectuent en parallèle dans le temps avec la formation d'image du motif de projection (104.3) sur le substrat (106.1).

27. Procédé d'imagerie selon la revendication 25 ou 26, **caractérisé en ce que**
- au moins l'un des composants (104, 106, 107, 108, 109, 110, 111, 112) participant à la formation d'image du motif de projection sur le substrat est un composant actif pouvant être commandé (112) et
- le composant actif pouvant être commandé (112) est commandé en fonction du défaut de formation d'image pour corriger au moins partiellement le défaut de formation d'image.
